# EUROPEAN PATENT SPECIFICATION

(11) **EP 3 385 218 B1**
(45) Date of publication and mention of the grant of the patent: **13.10.2021**
(21) Application number: 17164598.9
(22) Date of filing: 03.04.2017
(51) Int. Cl.: B81B 7/00

(54) **SEMICONDUCTOR DEVICE COMPRISING ENVIRONMENTAL SENSOR**
HALBLEITERBAUELEMENT MIT UMWELTSENSOR
DISPOSITIF SEMI-CONDUCTEUR COMPRENANT UN CAPTEUR ENVIRONNEMENTAL

(43) Date of publication of application: 10.10.2018
(73) Proprietor: Sciosense B.V., 5656 AE Eindhoven (NL)
(72) Inventor: Faes, Alessandro, 8141 Premstätten (AT); Siegert, Jörg, 8020 Graz (AT); Schrank, Franz, 8052 Graz (AT)
(74) Representative: Epping - Hermann - Fischer

(56) References cited:
- DE-A1-102015 116 353
- US-A1- 2016 370 242

## Description

The present application relates to a semiconductor device.

Semiconductor devices can comprise environmental sensors as, for example, pressure sensors. Several environmental sensors and especially pressure sensors are sensitive to stress. In order to keep the same conditions as during calibration of the sensors it is desired that no additional stress is exerted on the semiconductor device after the calibration. As in most cases the semiconductor devices are calibrated before they are incorporated into a final product, e.g. a mobile phone, additional stress can be exerted on the semiconductor device within the final product. If the additional stress is transferred to the environmental sensor it is less accurate.

DE 10 2015 116 353 A1 relates to a microintegrated sensor comprising a stack formed by a sensor layer, by a cap layer, and by an insulating layer. The sensor layer and the cap layer have a respective peripheral portion surrounding a central portion, and the insulating layer extends between the peripheral portions of the sensor layer and of the cap layer. An air gap extends between the central portions of the sensor layer and of the protection layer. A through trench extends into the central portion of the sensor layer as far as the air gap and surrounds a platform housing a sensitive element. The cap layer has through holes in the insulating layer that extend from the air gap and form a fluidic path with the air gap and the through trench.

US 2016/0370242 A1 relates to a pressure sensor comprising a first substrate with a buried cavity and a membrane suspended over the buried cavity, a second substrate having a recess, hermetically coupled to the first substrate such that the recess defines a sealed cavity, and a channel formed at least in part in the first substrate and configured to arrange the buried cavity in communication with the environment external to the pressure sensor.

It is furthermore desired to reduce the package height of semiconductor devices comprising an environmental sensor in order to include the semiconductor devices in mobile phones or other portable devices.

Additional stress induced on a semiconductor device can be avoided, for example by the use of thick glue layers or thick ceramic substrates. However, in both cases the thickness and also the footprint of the semiconductor device are increased, which is not desirable for applications in mobile phones or other portable devices.

It is an objective to improve the accuracy of the environmental sensor of the semiconductor device.

This objective is solved by the invention set out in the independent claim. Further embodiments are subject of dependent claims.

In one embodiment of the semiconductor device the semiconductor device comprises a cap body. The cap body can be a wafer, a substrate or a bulk material and it can comprise silicon, glass or a semiconductor.

The semiconductor device further comprises an environmental sensor. The environmental sensor can be a pressure sensor or, for example, a capacitive pressure sensor with a membrane. The cap body can be arranged on top of the environmental sensor. It is also possible that the semiconductor device comprises several environmental sensors.

The semiconductor device further comprises a substrate body. The substrate body can be a wafer, a substrate or a bulk material and it can comprise silicon or glass. The substrate body can comprise an integrated circuit and a substrate. It is also possible that the substrate body comprises glass with a coefficient of thermal expansion which is similar to the coefficient of thermal expansion of the cap body. The cap body and the substrate body can be of the same material or they can comprise different materials. The environmental sensor is arranged on top of the substrate body, for example on top of the integrated circuit.

The semiconductor device further comprises a first volume of gas. The environmental sensor and the first volume of gas are arranged between the substrate body and the cap body in a vertical direction which is perpendicular to the main plane of extension of the substrate body. The first volume of gas can be arranged above the environmental sensor in vertical direction and around the environmental sensor.

The semiconductor device further comprises a trench extending through at least a part of the substrate body in vertical direction, the trench being connected to the volume of gas and the vertical direction being perpendicular to lateral directions that are parallel to the main plane of extension of the semiconductor device. The trench can be arbitrarily shaped within the substrate body. The trench can further have the shape of a line or it can be L-shaped or U-shaped within a plane which is parallel to the main plane of extension of the semiconductor device. It is also possible that the trench has a rectangular or a square shape. This means, the trench can surround an area or a volume of the substrate body in the lateral directions. The trench can comprise an approximately uniform depth in vertical direction.

The trench can be formed within the substrate body by etching. For example, the trench can be etched in the substrate body before the cap body is bonded to the substrate body. The trench is not filled with a solid material but only with the gas surrounding the semiconductor device.

It is also possible that the semiconductor device comprises several trenches. The several trenches can surround the environmental sensor from different sides.

The trench is arranged next to or around the environmental sensor. In this way, the environmental sensor is decoupled from the substrate body. The environmental sensor can be arranged on the substrate body, however, by forming the trench next to or around the
environmental sensor the environmental sensor is less connected to the substrate body. Consequently, if stress is induced on the substrate body in vertical or in lateral directions the environmental sensor can be partially or mostly decoupled from this stress or the stress is at least not completely transferred to the environmental sensor. Also, if the semiconductor device is bent this external stress is not completely transferred to the environmental sensor.

The semiconductor device further comprises a channel connecting the first volume of gas and the trench with the environment of the semiconductor device such that the channel is permeable for gases. "Permeable for gases" in this case means that gases from the environment of the semiconductor device can reach the first volume of gas within the semiconductor device and the other way around. The channel can be arranged next to the environmental sensor in a lateral direction. According to the invention the channel extends in a lateral direction. The channel can have a diameter which is small in comparison to the lateral extension of the semiconductor device and it can also be a channel with a lateral extension which is similar to the lateral extension of the semiconductor device. The substrate body and the cap body can be connected with each other via a bonding material. The bonding material is arranged between the substrate body and the cap body, and the bonding material comprises at least one of the following: a polymer, a photo-definable glue, a non-photosensitive glue, a metal, an oxide, a nitride. The bonding material can be applied on the substrate body as a foil or via spin coating in the case of glue. The cap body and the substrate body can be connected with each other by, for example, gluing, fusion bonding or eutectic bonding. By connecting the cap body and the substrate body an airtight connection can be formed, except for the channel. In another embodiment the bonding material is applied by Physical Vapor Deposition (PVD), Chemical Vapor Deposition (CVD), Plasma Enhanced Chemical Vapor Deposition (PECVD) and or Atomic Layer Deposition (ALD). The channel can be formed in the bonding material, therefore the bonding material can be patterned by lithographic etching. The semiconductor device can comprise several channels within the bonding material.

It is also possible that the channel is formed at another position in the semiconductor device.

Since the cap body is arranged on top of the substrate body and the environmental sensor the thickness of the semiconductor device is increased and also the stiffness of the semiconductor device is increased. Therefore, additional vertical stress on the environmental sensor or on integrated circuits in the semiconductor device is reduced. Additional stress on the environmental sensor can be further reduced by arranging the trench next to or around the environmental sensor. In this way, the environmental sensor is less connected to the substrate body and decoupled from the substrate body and external stress. Consequently, the environmental sensor is also decoupled from external stress when the semiconductor device is incorporated in a final product. As no or nearly no additional stress is induced on the environmental sensor in comparison to during calibration the accuracy of the environmental sensor is increased.

Furthermore, the environmental sensor is protected by the cap body during processing. Moreover, the substrate body can be thin enough to introduce an electrically conductive via or other electrical contacts in the substrate body since the cap body increases the total thickness of the semiconductor device.

By forming a stiff package without the use of glue layers or thick substrates, the footprint and the cost of the device can be reduced.

In one embodiment of the semiconductor device the environmental sensor comprises a pressure sensor. The pressure sensor can for example be a capacitive pressure sensor. The capacitive pressure sensor can comprise a cavity below a membrane. The advantages of capacitive pressure sensing are a low power consumption, a high sensitivity and a high resolution. Furthermore, it can be integrated directly on top of an integrated circuit. With this, the footprint of the device can be reduced.

In one embodiment of the semiconductor device a closing body is arranged at the side of the substrate body that faces away from the environmental sensor. This means, the substrate body is arranged between the cap body and the closing body. The closing body can be a wafer, a substrate or a bulk material and it can comprise silicon or glass. It is also possible that the closing body comprises glass with a coefficient of thermal expansion which is similar to the coefficient of thermal expansion of the cap body and the substrate. The closing body, the cap body and the substrate body can be of the same material or they can comprise different materials. The closing body can be connected with the substrate body in the same way as the cap body is connected with the substrate body. It is also possible that the closing body is bonded to the substrate body by one of the bond materials or methods described above.

Preferably, the substrate body is thinned before the closing body is connected with the substrate body in order to reduce the total thickness of the semiconductor device.

In one embodiment of the semiconductor device the channel is arranged within the closing body. This means, the channel can be a channel which is completely arranged within the closing body. It is also possible that the channel is arranged between the substrate body and the closing body in the semiconductor device by patterning the closing body in such a way that the channel is formed within the closing body. Consequently, the bonding material between the substrate body and the cap body does not have to be patterned in order to form the channel.

In other embodiments it is possible that the channel is arranged between the substrate body and the cap body for example within a bonding material. It is also possible that the channel is formed in the cap body or in the substrate body.

In one embodiment of the semiconductor device the closing body comprises at least one electrically conductive via. The electrically conductive via can extend in a vertical direction from the top side of the closing body, which faces away from the substrate body, towards the substrate body. The electrically conductive via electrically contacts the environmental sensor or another electrical contact, for example a back contact of an integrated circuit. The electrically conductive via can be a through silicon via which is formed by patterning of the closing body, for example by etching. A via patterned in the closing body can be coated with an isolation material and with an electrically conductive material to contact the environmental sensor.

If the electrical contact of the environmental sensor or the back contact of the integrated circuit is not arranged on the side of the substrate body facing away from the closing body, the electrically conductive via also extends through the substrate body towards the electrical contact of the environmental sensor or the back contact of the integrated circuit. If the closing body and the substrate body are connected via direct bonding, advantageously in this embodiment only the closing body or the closing body and the substrate body need to be etched in order to form an electrically conductive via but no other material as for example a bonding material. For other materials than the closing body and the substrate body the etching process can be more complicated.

In one embodiment of the semiconductor device the trench is arranged next to the environmental sensor in lateral direction. This means the trench is not positioned below or above the environmental sensor in a vertical direction. It is also possible that the trench is arranged next to the environmental sensor in different lateral directions. With the trench being arranged next to the environmental sensor, the environmental sensor is decoupled from the substrate body and thus it is also decoupled from external stress.

The environmental sensor is in direct contact with the first volume of gas. This means, the first volume of gas can be arranged above the environmental sensor in vertical direction or around the environmental sensor. "In direct contact" further means that if the environmental sensor comprises a pressure sensor, it can measure the pressure in the first volume of gas which is similar or the same as the pressure in the environment of the semiconductor device, since the first volume of gas is connected with the channel. Thus, the pressure sensor can advantageously measure the pressure in the environment of the semiconductor device.

In one embodiment of the semiconductor device the trench at least partially surrounds a decoupling portion in lateral directions, where the decoupling portion comprises the environmental sensor. The decoupling portion can be a volume of material which comprises for example a part of the substrate body and the environmental sensor. The decoupling portion can for example be a cuboid. The trench directly borders the decoupling portion such that the trench gives the limit of the decoupling portion. If for example the trench is arranged around the environmental sensor the decoupling portion is the volume of material that is surrounded by the trench. The decoupling portion is at least partially decoupled from the substrate body in order to reduce external stress on the environmental sensor. It is possible that the trench is formed in such a way that the decoupling portion is connected to the substrate body. The more the decoupling portion is decoupled from the substrate body the less external stress is exerted on the environmental sensor. Preferably, there is only one connection point between the decoupling portion and the substrate body.

In one embodiment of the semiconductor device a second volume of gas is arranged at the side of the decoupling portion which faces away from the environmental sensor. This means, the second volume of gas can be arranged between the substrate body and the closing body. The lateral extent of the second volume of gas can be the same as the lateral extent of the decoupling portion. For forming the second volume of gas the closing body can be patterned or comprise one or more recesses. The second volume of gas can be connected with the trench and with the channel such that the second volume of gas is also connected to the environment of the semiconductor device.

With the second volume of gas being arranged at the side of the decoupling portion which faces away from the environmental sensor the decoupling portion is further decoupled from the substrate body and also from the closing body. Therefore, the environmental sensor is further decoupled from external stress.

In one embodiment of the semiconductor device the decoupling portion comprises a further environmental sensor. The further environmental sensor can be arranged next to the environmental sensor. The further environmental sensor can be the same type of sensor as the environmental sensor. The trench is arranged next to or around the two environmental sensors. It is also possible, that two trenches are arranged next to or around the two environmental sensors. Advantageously, with two environmental sensors it is possible to arrange the environmental sensors and the one or more trenches in a symmetrical arrangement.

In one embodiment of the semiconductor device the decoupling portion is connected to the cap body. The decoupling portion can be connected to the cap body with a bonding material between the cap body and the substrate body. It is possible that the decoupling portion is only connected to the cap body and not to the substrate body. In this way, the environmental sensor is further decoupled from external stress.

In one embodiment of the semiconductor device the environmental sensor is arranged on an integrated circuit. The environmental sensor can be arranged on top of the final passivation layer of a complementary metal oxide semiconductor device readout circuit. With this arrangement the total lateral size of the semiconductor device can be reduced. Moreover, the additional stress is also minimized for the integrated circuit and not only for the environmental sensor since the integrated circuit is protected by the substrate body and the cap body.

In one embodiment the semiconductor device is airtight except for the channel. This means that the semiconductor device comprises no other openings or channels than the at least one channel which connects the first volume of gas with the environment of the semiconductor device. In this case "airtight" means that only the at least one channel is permeable for gases from the environment of the semiconductor device to the first volume of gas and the other way around. With this arrangement a pressure sensor in the semiconductor device can sense the pressure of the gas surrounding the semiconductor device. The opening of the channel towards the environment of the semiconductor device can be positioned at a side surface of the semiconductor device. This arrangement is advantageous for the processing of the semiconductor device since it can be vacuum-picked at the cap body or the substrate body and the respective other side of the semiconductor device can be processed.

In one embodiment of the semiconductor device the cap body comprises at least one electrically conductive via. The electrically conductive via can extend within the cap body in vertical direction from the side of the environmental sensor towards a bottom side of the cap body which faces away from the substrate body. The electrically conductive via electrically contacts the environmental sensor or another electrical contact, for example a back contact of an integrated circuit of the substrate body. The electrically conductive via can be a through silicon via which is formed by patterning of the cap body, for example by etching. The electrically conductive via can be electrically contacted on the bottom side of the semiconductor device by a solder ball.

The following description of figures may further illustrate and explain exemplary embodiments. Components that are functionally identical or have an identical effect are denoted by identical references. Identical or effectively identical components might be described only with respect to the figures where they occur first. Their description is not necessarily repeated in successive figures.

With figures 1A to 1J, a method for forming an exemplary embodiment of a semiconductor device is described.

In figures 2A to 2D, another method for forming an exemplary embodiment of a semiconductor device is shown.

Figure 3 shows a top view of an exemplary embodiment of the semiconductor device.

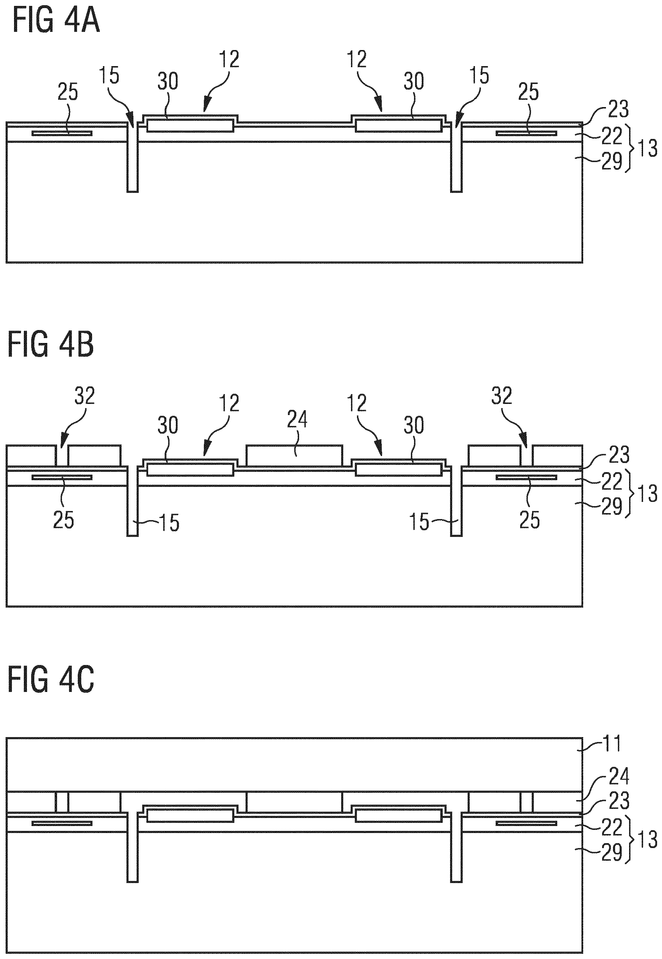

With figures 4A to 4L, another method for forming an exemplary embodiment of a semiconductor device is described.

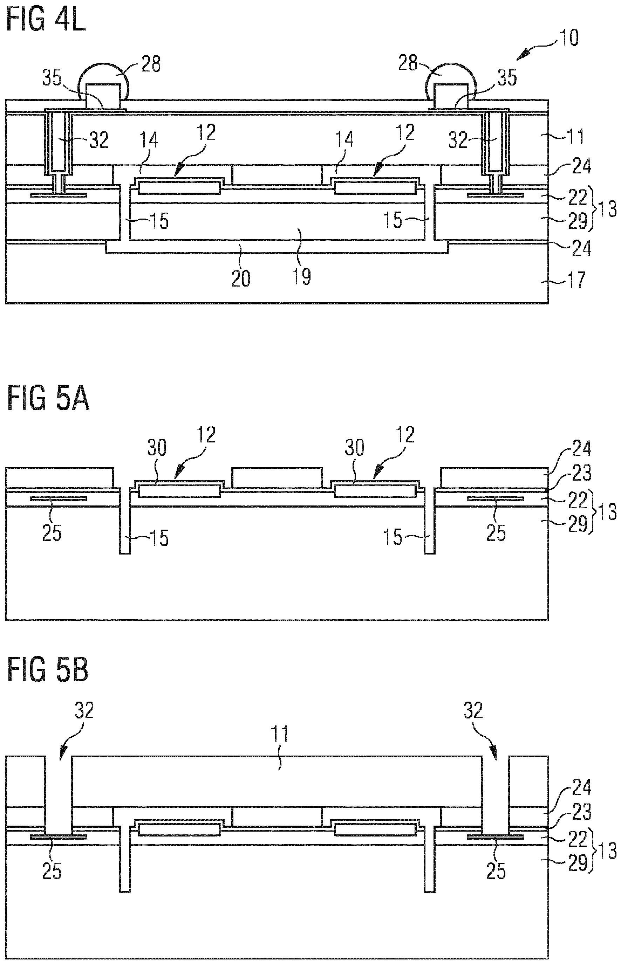

In figures 5A to 5D, another method for forming an exemplary embodiment of a semiconductor device is shown.

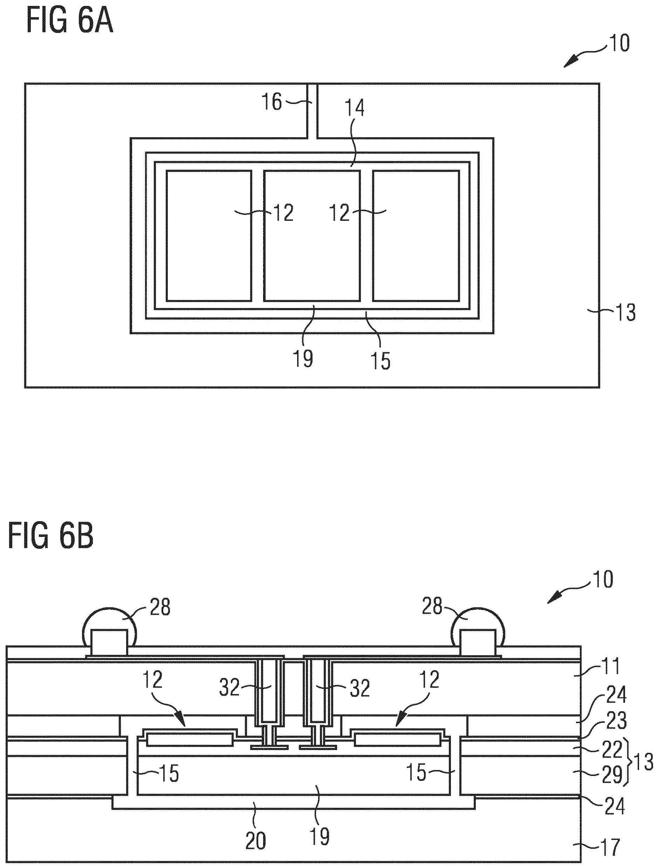

Figure 6A shows a top view of an exemplary embodiment of the semiconductor device.

Figure 6B shows a cutaway view of an exemplary embodiment of the semiconductor device.

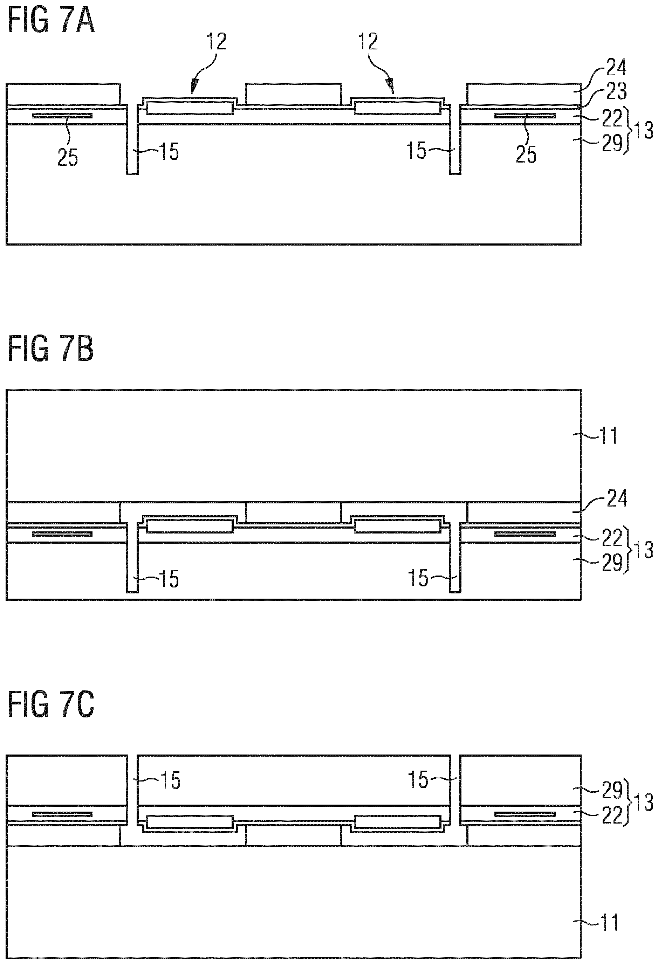

With figures 7A to 7G, another method for forming an exemplary embodiment of a semiconductor device is described.

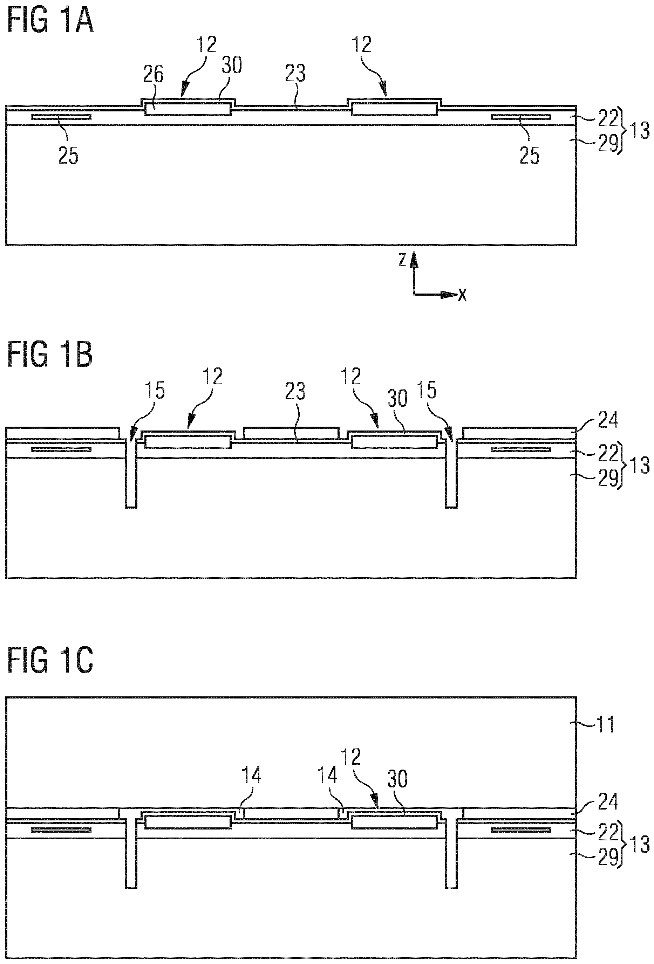

Figure 1A shows a processing step for forming a semiconductor device 10. A cutaway view of a substrate body 13 is shown which comprises an integrated circuit 22 which can be for example a complementary metal oxide semiconductor device. The integrated circuit 22 is arranged on top of a substrate 29 in a vertical direction z where the substrate 29 is comprised by the substrate body 13 and it can comprise silicon or glass. The vertical direction z is perpendicular to the main plane of extension of the semiconductor device 10. The integrated circuit 22 comprises two metal layers 25. It is also possible that the integrated circuit 22 comprises more than two metal layers 25 or other electrical contacts. On top of the integrated circuit 22 two environmental sensors 12 are arranged. In this embodiment the environmental sensors 12 are capacitive pressure sensors. By arranging the environmental sensors 12 on top of the integrated circuit 22 instead of next to it, the footprint of the semiconductor device 10 is reduced. The environmental sensors 12 are arranged between the two metal layers 25 in a lateral direction x which is perpendicular to the vertical direction z. In this exemplary embodiment the environmental sensors 12 comprise a cavity 26 below a membrane 30. The environmental sensors 12 are electrically connected to the integrated circuit 22. In order to close the cavity 26 a sealing layer 23 is deposited on top of the released membrane 30 and around the membrane 30 such that the membrane 30 is sensitive to differences in pressure. The sealing layer 23 can comprise silicon nitride.

In figure 1B, it is shown that a bonding material 24 is applied to the sealing layer 23. The bonding material 24 can comprise a photo-sensitive glue layer which can be polymer based or polyimide based. By applying a mask, the bonding material 24 is patterned in such a way that it is removed from the area above the membrane 30 and around the membrane 30. Additionally, two trenches 15 are formed within the substrate body 13. They can be formed for example by etching. The two trenches 15 extend through a part of the substrate body 13 in vertical direction z and they are arranged next to the environmental sensors 12. It is also possible that the trenches 15 are formed before applying the bonding material 24.

As shown in figure 1C in a next step a cap body 11 is attached to the bonding material 24. The cap body 11 can be connected with the bonding material 24 at elevated temperatures. The cap body 11 can comprise silicon, glass, or glass with a coefficient of thermal expansion which is similar to the coefficient of thermal expansion of the substrate body 13. Above the environmental sensors 12 and between the cap body 11 and the substrate body 13 two first volumes of gas 14 are formed where each of the first volumes of gas 14 is in direct contact with one of the environmental sensors 12, respectively. The membranes 30 of the environmental sensors 12 are advantageously protected at this early stage of the processing. Furthermore, both the surface of the cap body 11 that faces away from the environmental sensors 12 and the surface of the substrate body 13 that faces away from the environmental sensors 12 are flat and easy to handle during processing while the environmental sensors 12 are protected. Therefore, the membrane 30 of the environmental sensor 12 is never exposed to handling during processing.

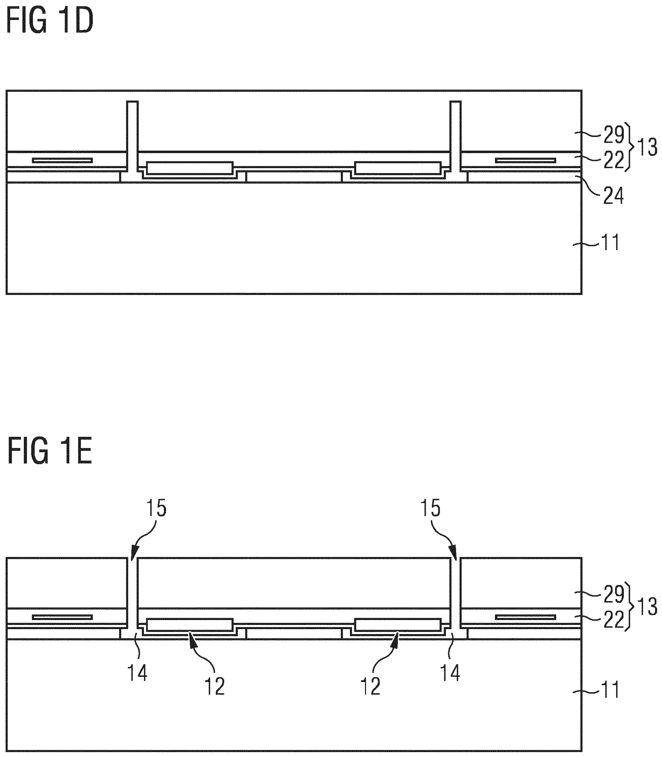

In figure 1D it is shown that in the next step the substrate body 13 is thinned, for example by grinding. In this way, the total height of the semiconductor device 10 is reduced.

As shown in figure 1E the substrate body 13 is further thinned by dry etching such that the trenches 15 are opened from the side of the substrate body 13 which faces away from the environmental sensors 12. Via the first volumes of gas 14 and the trenches 15 the environmental sensors 12 are in contact with the gas of the environment of the semiconductor device 10.

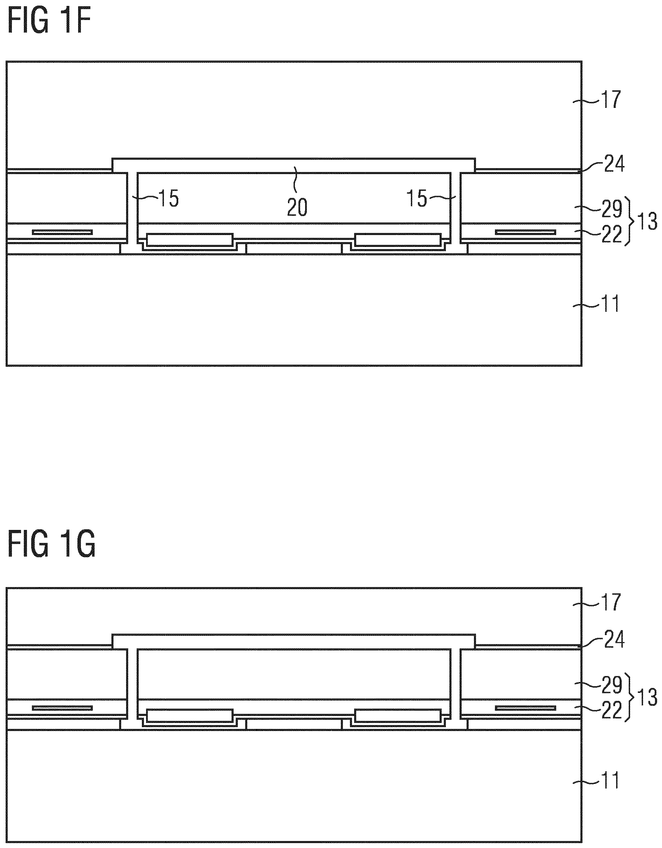

In figure 1F it is shown that in a next step a closing body 17 is connected with the substrate body 13 at the side of the substrate body 13 which faces away from the environmental sensors 12 via the bonding material 24. The closing body 17 can be connected with the substrate body 13 in the same way as the substrate body 13 is connected with the cap body 11. The closing body 17 is patterned at one side in such a way that between the closing body 17 and the substrate body 13 a second volume of gas 20 is formed. This means, the closing body 17 comprises a recess at one side. The second volume of gas 20 is connected with the two trenches 15. The lateral extent of the second volume of gas 20 is slightly larger than the lateral distance between the two trenches 15.

In figure 1G it is shown that in the next step the closing body 17 is thinned, for example by grinding.

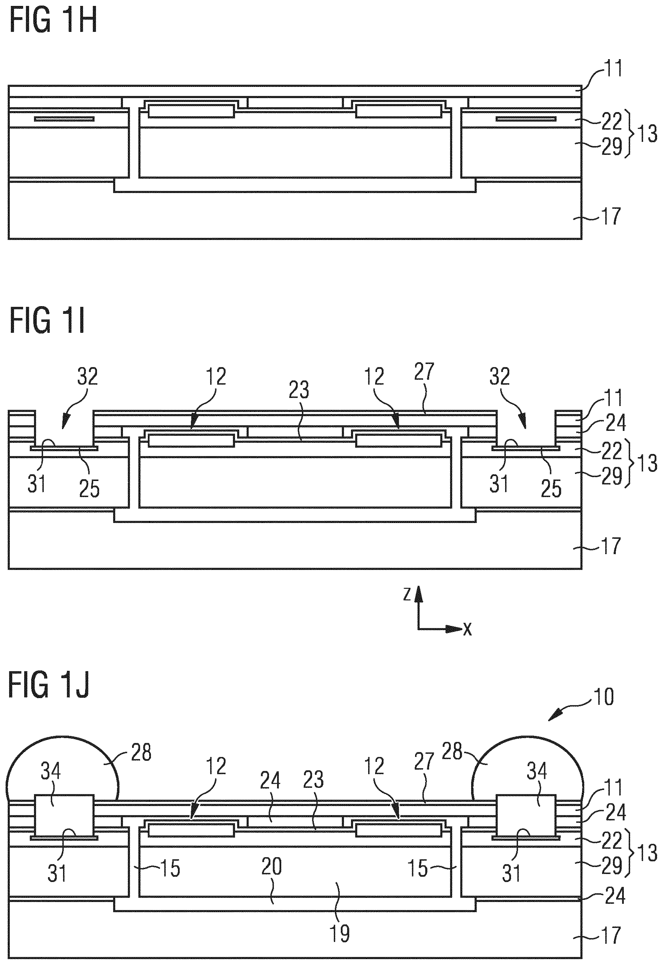

As shown in figure 1H the cap body 11 is thinned as well, for example by grinding.

As shown in figure 1I in a next step a passivation layer 27 is applied to the side of the cap body 11 which faces away from the substrate body 13. In order to form an electric contact to the integrated circuit 22; the passivation layer 27, the cap body 11, the bonding material 24 and the sealing layer 23 are etched away above the two metal layers 25 of the integrated circuit 22. This means, two vias 32 and two contact areas 31 are formed next to the environmental sensors 12 in lateral direction x. The two metal layers 25 act as etch stop layers.

In figure 1J it is shown that the vias 32 are filled with an electrically conductive material 34 and that the two contact areas 31 are electrically contacted with solder balls 28. The electrically conductive material 34 can be the same material as the solder balls 28. Consequently, the semiconductor device 10 can be electrically contacted at the side of the cap body 11 which faces away from the substrate body 13. By forming the two trenches 15 and the second volume of gas 20, a decoupling portion 19 of the substrate body 13 which comprises the two environmental sensors 12 is formed. The decoupling portion 19 is decoupled from the substrate body 13. It is possible that the trenches 15 completely surround the decoupling portion 19 from all lateral sides. It is also possible that the decoupling portion 19 is not connected to the closing body 17 as the second volume of gas 20 is arranged between the decoupling portion 19 and the closing body 17. This means, it is possible that the decoupling portion 19 is only connected to the cap body 11 via the bonding material 24 between the cap body 11 and the substrate body 13. Therefore, if external stress is exerted on the semiconductor device 10 the decoupling portion 19 with the two environmental sensors 12 is decoupled from most parts of the semiconductor device 10 and thus it is also decoupled from external stress. Consequently, the environmental sensors 12 are also decoupled from external stress when the semiconductor device 10 is incorporated in a final product. As no or nearly no additional stress is induced on the environmental sensors 12 in comparison to during calibration the accuracy of the environmental sensors 12 is increased.

It is not shown in figure 1J that the semiconductor device 10 comprises a channel 16 connecting the first volume of gas 14 and the trenches 15 with the environment of the semiconductor device 10 such that the channel 16 is permeable for gases. This means, the semiconductor device 10 is air-tight except for the channel 16. The channel 16 can be arranged for example within the closing body 17 or between the closing body 17 and the substrate body 13.

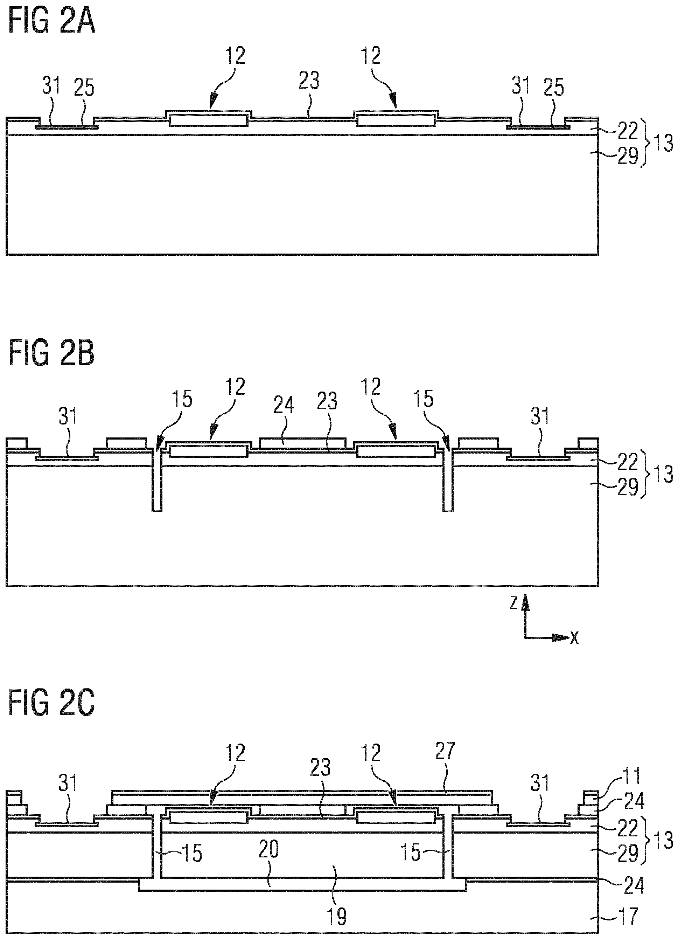

With figures 2A to 2D an alternative method for forming a semiconductor device 10 is shown. In figure 2A an alternative process step after the step shown in figure 1A is depicted. After the deposition of the sealing layer 23 on the integrated circuit 22 and the environmental sensors 12 which are arranged on the substrate 29, the sealing layer 23 and a part of the integrated circuit 22 are etched away above the two metal layers 25. In this way, two contact areas 31 are formed where the integrated circuit 22 can be electrically contacted.

In figure 2B it is shown that the bonding material 24 is applied to the surface of the substrate body 13 on top of the sealing layer 23. The bonding material 24 is patterned in such a way that the contact areas 31 and the environmental sensors 12 are free of the bonding material 24. Furthermore, an area of the sealing layer 23 around the contact areas 31 and the environmental sensors 12 is free of the bonding material 24. Additionally, two trenches 15 are formed within the substrate body 13 by etching. The trenches 15 extend through a part of the substrate body 13 in vertical direction z and they are arranged next to the environmental sensors 12.

In figure 2C it is shown that the next steps of the alternative method are the same steps as shown in figures 1C to 1H. After the thinning of the cap body 11 a passivation layer 27 is applied to the side of the cap body 11 which faces away from the substrate body 13. In contrast to the method shown in figures 1A to 1J in this case only the cap body 11 with the passivation layer 27 is etched away above the contact areas 31, as the bonding material 24 and the sealing layer 23 were already etched away in a previous step. The cap body 11 with the passivation layer 27 is etched further in the lateral direction x than the bonding material 24. In this way a stepped structure is formed around the contact areas 31 including the sealing layer 23, the bonding material 24 and the cap body 11 with the passivation layer 27.

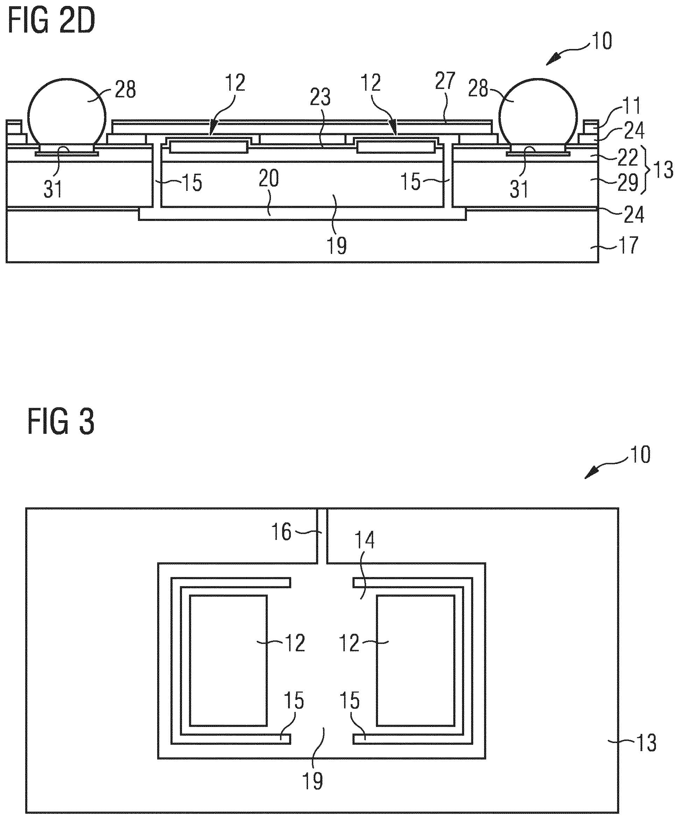

As shown in figure 2D the contact areas 31 are electrically contacted by solder balls 28. However, in this case the solder balls 28 are only in contact with the contact area 31 and do not touch any other part of the semiconductor device 10. Therefore, leakage currents from the solder balls 28 through other areas than the contact areas 31 are avoided.

Figure 3 shows a top view of an exemplary embodiment of a semiconductor device 10 which is formed by one of the methods shown in figures 1A to 1J and 2A to 2D. The top view in figure 3 is not a cut through one plane of the semiconductor device 10 but it shows several parts of the semiconductor device 10 seen from the top. Two environmental sensors 12 are arranged on a decoupling portion 19. Each environmental sensor 12 is surrounded by a U-shaped trench 15. Preferably, the two trenches 15 are located very close to each other, this means, they are almost connected with each other. A channel 16 is connected with the trenches 15 and the first volume of gas 14 which is arranged above the two environmental sensors 12. The channel 16 is arranged within the closing body 17. The lateral extent of the decoupling portion 19 gives the approximate lateral extent of the second volume of gas 20 which is also connected to the trenches 15. The two environmental sensors 12 are surrounded by the substrate body 13 which can comprise an integrated circuit 22.

With figures 4A to 4L, another method for forming an exemplary embodiment of the semiconductor device 10 is described. In figure 4A it is shown that the substrate body 13 comprises the substrate 29 and the integrated circuit 22 with two metal layers 25. Two environmental sensors 12 are arranged on top of the substrate body 13. The two environmental sensors 12 and the integrated circuit 22 are covered by the sealing layer 23. Two vertical trenches 15 are etched in a part of the substrate body 13 next to the environmental sensors 12.

In figure 4B, it is shown that a bonding material 24 is applied to the sealing layer 23. By applying a mask, the bonding material 24 is patterned in such a way that it is removed from the area above the membrane 30 and around the membrane 30 and from the trenches 15. Additionally, two vias 32 are formed within the bonding material 24 above the metal layers 25 where the lateral extent of the vias 32 is smaller than the lateral extent of the metal layers 25. It is also possible that the trenches 15 are only formed after applying the bonding material 24.

As shown in figure 4C in a next step the cap body 11 is bonded to the substrate body 13 with the bonding material 24. Furthermore, the cap body 11 is thinned, for example by grinding.

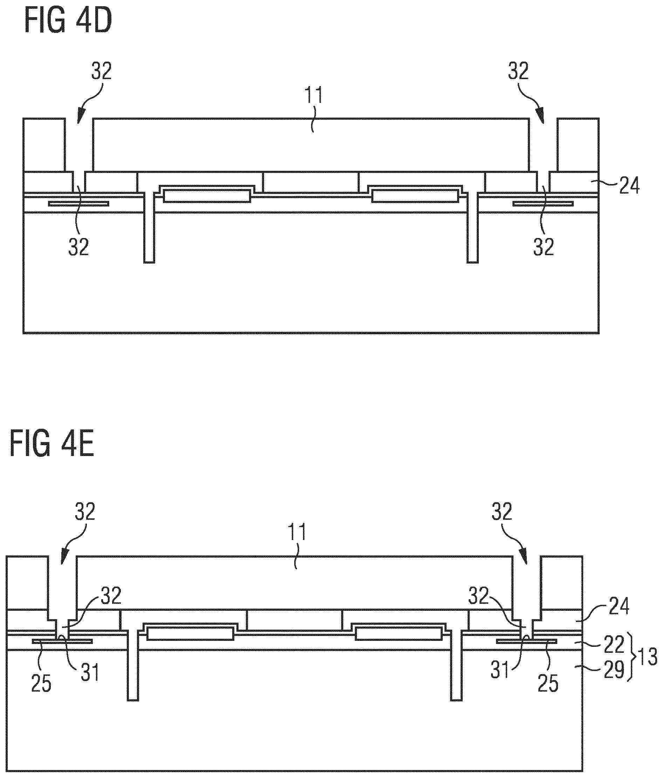

In the next step as shown in figure 4D two vias 32 are etched in the cap body 11 above the vias 32 within the bonding material 24. The lateral extent of the vias 32 within the cap body 11 is larger than the lateral extent of the vias 32 within the bonding material 24.

In figure 4D it is shown that the vias 32 within the bonding material 24 are further etched and the material above the metal layers 25 is etched away within the vias 32 of the bonding material 24. This means vias 32 are formed from the side of the cap body 11 facing away from the substrate body 13 towards the metal layers 25 such that contact areas 31 are formed. At the contact areas 31 the integrated circuit 22 can be electrically contacted.

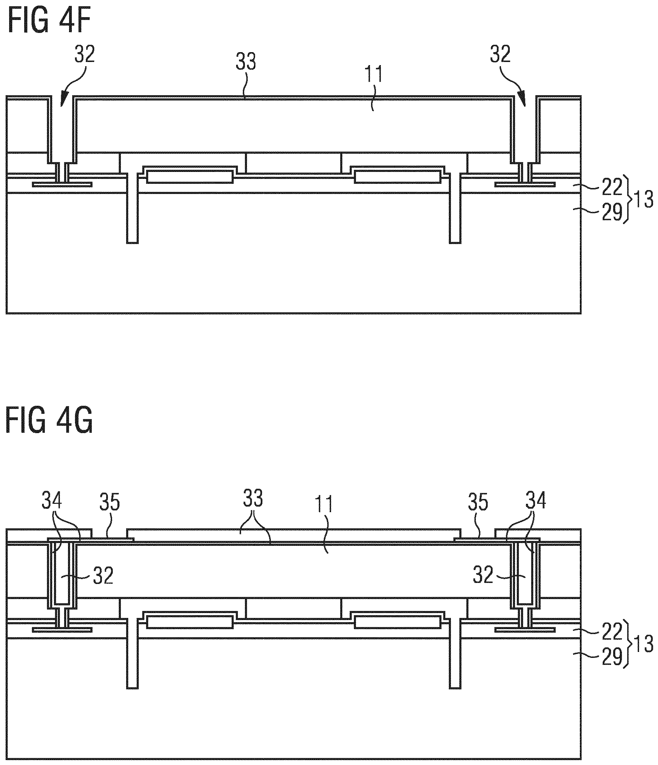

As shown in figure 4F an isolation layer 33 is deposited on the side of the cap body 11 that faces away from the substrate body 13 and within the vias 32.

In figure 4G it is shown that an electrically conductive material 34 is deposited within the vias 32. The electrically conductive material 34 can for example comprise Cu or W. The vias 32 are not completely filled with the electrically conductive material 34. However, it is also possible that the vias 32 are completely filled with the electrically conductive material 34. At the side of the cap body 11 that faces away from the substrate body 13 two back contacts 35 are formed by depositing an electrically conductive material 34 on and around the vias 32. Another isolation layer 33 is deposited at the side of the cap body 11 that faces away from the substrate body 13. The isolation layer 33 is patterned in such a way that the back contacts 35 are free of the isolation layer 33. Thus, the vias 32 are electrically conductive.

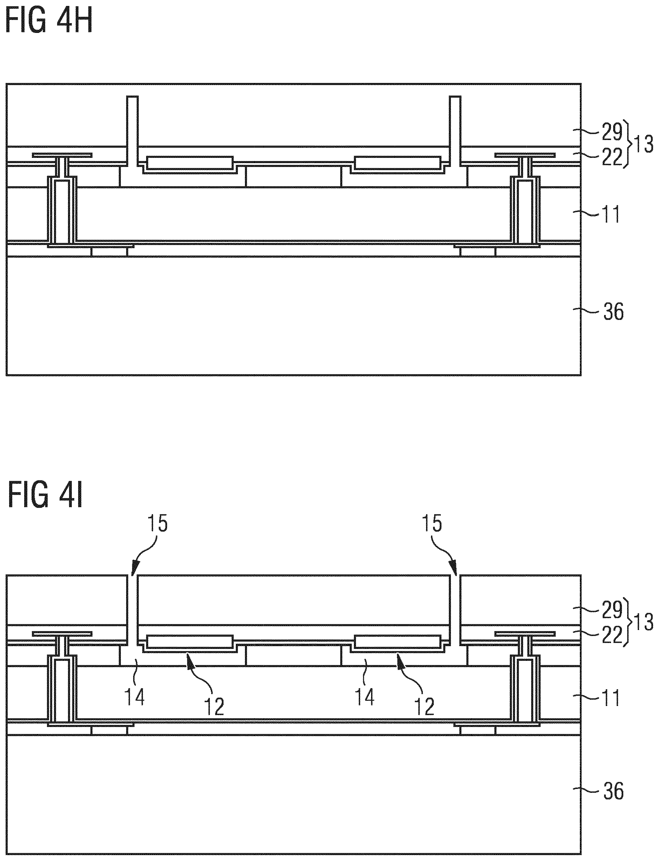

As shown in figure 4H in a next step a handling wafer 36 is attached at the side of the cap body 11 that faces away from the substrate body 13. Additionally, the substrate body 13 is thinned at the side that faces away from the cap body 11.

As shown in figure 4I the substrate body 13 is further thinned by dry etching such that the trenches 15 are opened from the side of the substrate body 13 which faces away from the environmental sensors 12. Via the first volumes of gas 14 and the trenches 15 the environmental sensors 12 are in contact with the gas of the environment of the semiconductor device 10.

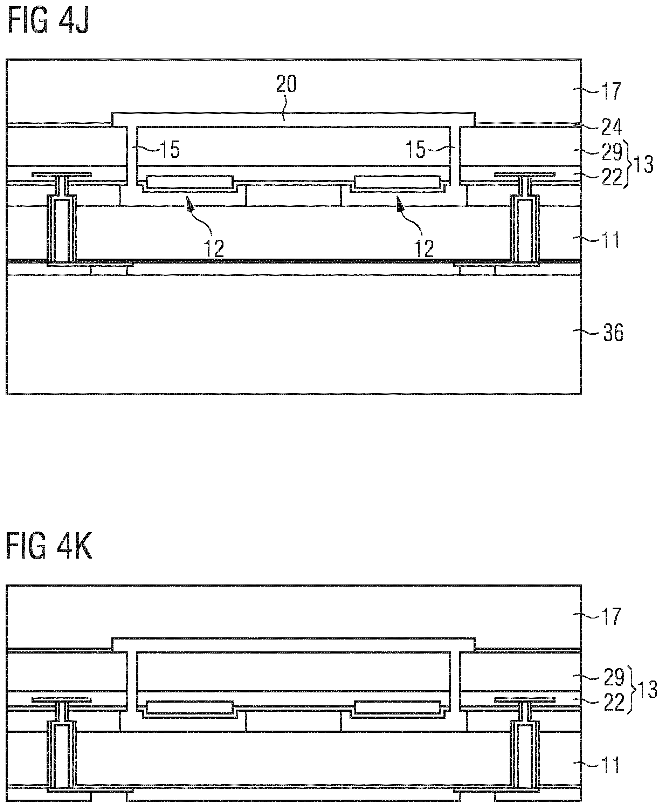

In figure 4J it is shown that in a next step a closing body 17 is connected with the substrate body 13 at the side of the substrate body 13 which faces away from the environmental sensors 12 via a bonding material 24. The closing body 17 is patterned at one side in such a way that between the closing body 17 and the substrate body 13 a second volume of gas 20 is formed. The second volume of gas 20 is connected with the two trenches 15. Moreover, the closing body 17 is thinned at the side that faces away from the substrate body 13.

In a next step as shown in figure 4K the handling wafer 36 is removed.

In figure 4L it is shown that the back contacts 35 are electrically contacted by solder balls 28.

With figures 5A to 5D an alternative method for forming a semiconductor device 10 is shown. In figure 5A an alternative process step after the step shown in figure 4A is depicted. The bonding material 24 is applied to the sealing layer 23. In difference to figure 4B, the bonding material 24 is only removed from the area above the membrane 30 and around the membrane 30. The two trenches 15 are etched in the substrate body 13 next to the environmental sensors 12.

As shown in figure 5B the cap body 11 is bonded to the substrate body 13 with the bonding material 24. By etching the cap body 11, the bonding material 24 and the sealing layer 23 above the two metal layers 25 two vias 32 are formed. The two vias 32 extend in vertical direction z and comprise an approximately constant diameter. This method shown in figures 5A and 5B can be applied instead of the method shown in figures 4A to 4D if it is possible to etch the bonding material 24 in the step shown in figure 5B. If it is not possible to etch the bonding material 24 because of its material properties a glue or a dry film which can be patterned can be employed as the bonding material 24 in the step shown in figure 4B.

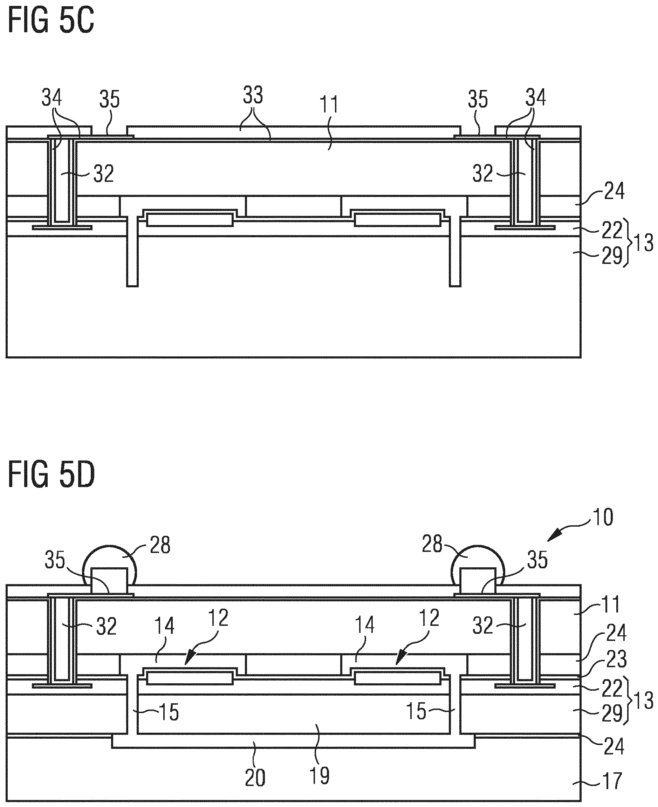

In figure 5C it is shown that back contacts 35 and electrically conductive vias 32 are formed as described with figures 4F and 4G.

In figure 5D it is shown that the electric back contacts 35 are electrically contacted by solder balls 28. The closing body 17 is arranged at the side of the substrate body 13 that faces away from the cap body 11 as described with figures 4H to 4J.

Figure 6A shows a top view of an exemplary embodiment of a semiconductor device 10. The top view in figure 6A is not a cut through one plane of the semiconductor device 10 but it shows several parts of the semiconductor device 10 seen from the top. Two environmental sensors 12 are arranged on a decoupling portion 19 and they are surrounded by a rectangular shaped trench 15. A channel 16 is connected with the trench 15 and with the first volume of gas 14 which is arranged above the two environmental sensors 12. The lateral extent of the decoupling portion 19 gives the approximate lateral extent of the second volume of gas 20 which is also connected to the trench 15. The two environmental sensors 12 are surrounded by the substrate body 13 which can comprise an integrated circuit 22. The rectangular shaped area between the two environmental sensors 12 marks the connection of the decoupling portion 19 to the cap body 11. In this embodiment the decoupling portion 19 is only connected with the cap body 11 but not with the substrate body 13.

Figure 6B shows a cutaway view of the exemplary embodiment of the semiconductor device 10 depicted in figure 6A. The two electrically conductive vias 32 which extend through the cap body 11 are arranged between the two environmental sensors 12 in lateral direction x. The two vias 32 can be formed as described with figures 4A to 4G or 5A to 5D. The trench 15 laterally surrounds the decoupling portion 19 with the two environmental sensors 12 from all lateral sides. The second volume of gas 20 is arranged between the decoupling portion 19 and the closing body 17 such that the decoupling portion 19 and the closing body 17 are not in contact with each other. This means, the decoupling portion 19 is only connected with the cap body 11 but not with the substrate body 13. In this way, the environmental sensors 12 are further decoupled from external stress and a bending of the decoupling portion 19 is avoided.

With figures 7A to 7G, another method for forming an exemplary embodiment of the semiconductor device 10 is described. In figure 7A the substrate body 13 with the bonding material 24 is depicted as described with figure 1B.

In a next step as shown in figure 7B the cap body 11 is connected with the substrate body 13 via the bonding material 24. The substrate body 13 is thinned such that the trenches 15 are still closed.

In figure 7C it is shown that the substrate body 13 is further thinned by dry etching as described with figure 1E.

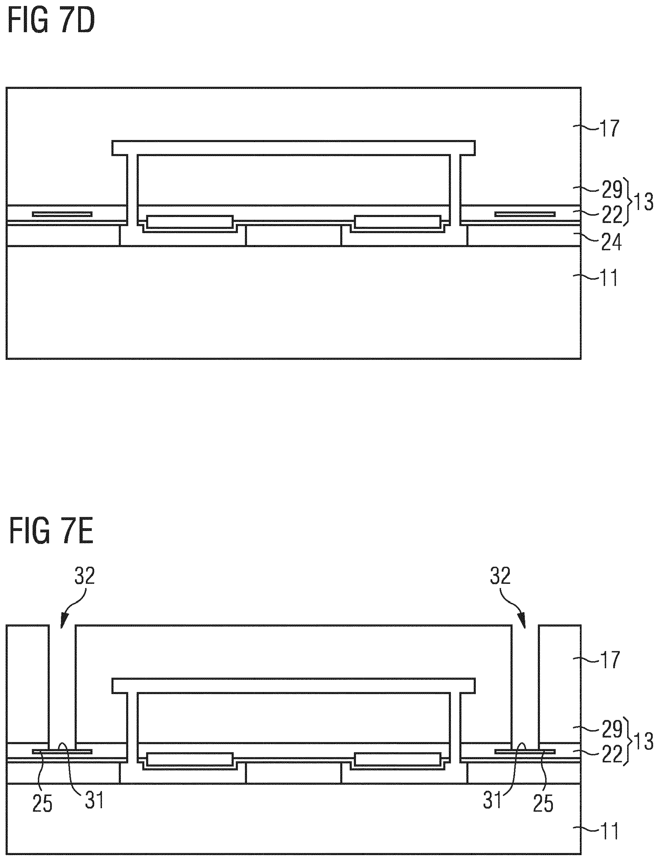

In figure 7D it is shown that the closing body 17 is connected with the substrate body 13 via direct bonding. Both the substrate body 13 and the closing body 17 comprise silicon. Additionally, the cap body 11 is thinned.

As shown in figure 7E two vias 32 are etched in the closing body 17 and the substrate body 13 above the metal layers 25. This means, all material above the two metal layers 25 is etched away such that contact areas 31 are formed. The two vias 32 extend in vertical direction z and comprise an approximately constant diameter.

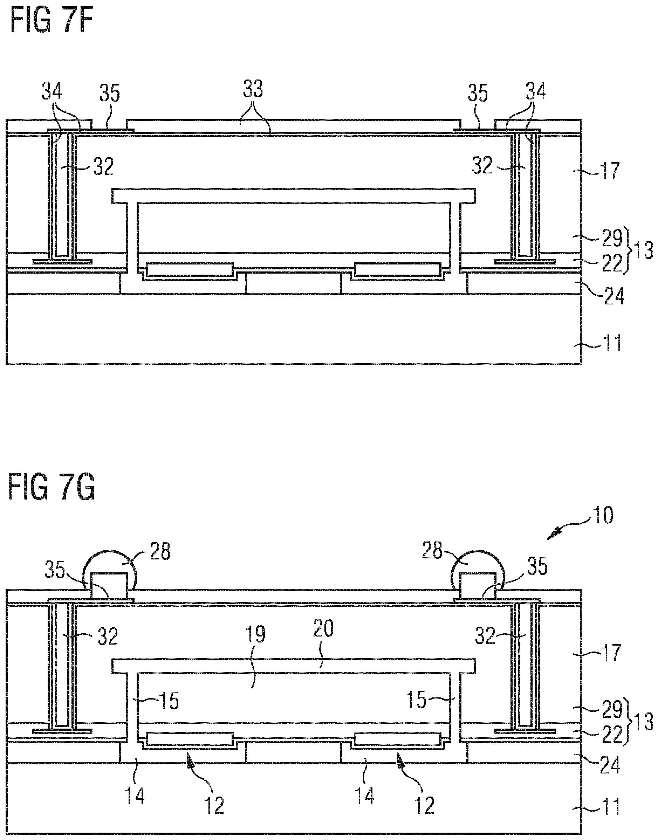

In a next step as shown in figure 7F back contacts 35 and electrically conductive vias 32 are formed as described with figures 4E to 4G.

In figure 7G it is shown that the back contacts 35 are electrically contacted by solder balls 28. In this alternative method described with figures 7A to 7G the vias 32 are formed by etching only through the closing body 17 and the substrate body 13 but not through the bonding material 24. In this way, the etching process can be simplified.

### List of reference numerals

- 10:: semiconductor device
- 11:: cap body
- 12:: environmental sensor
- 13:: substrate body
- 14:: first volume of gas
- 15:: trench
- 16:: channel
- 17:: closing body
- 19:: decoupling portion
- 20:: second volume of gas
- 21:: further environmental sensor
- 22:: integrated circuit
- 23:: sealing layer
- 24:: bonding material
- 25:: metal layer
- 26:: cavity
- 27:: passivation layer
- 28:: solder ball
- 29:: substrate
- 30:: membrane
- 31:: contact area
- 32:: via
- 33:: isolation layer
- 34:: electrically conductive material
- 35:: back contact
- 36:: handling wafer
- x:: lateral direction
- z:: vertical direction

## Claims

1. Semiconductor device (10), comprising:
- a cap body (11),
- an environmental sensor (12),
- a substrate body (13),
- a first volume of gas (14),
- a trench (15) extending through at least a part of the substrate body (13) in a vertical direction (z), the trench (15) being connected to the first volume of gas (14) and the vertical direction (z) being perpendicular to lateral directions (x) that are parallel to the main plane of extension of the semiconductor device (10), wherein
- the trench (15) is arranged next to or around the environmental sensor (12) in lateral direction (x),
- the environmental sensor (12) is in direct contact with the first volume of gas (14), and
- the environmental sensor (12) and the first volume of gas (14) are arranged between the cap body (11) and the substrate 25 body (13) in vertical direction (z) , **characterised in that** the semiconductor device (10) further comprises a channel (16) extending in a lateral direction (x) and connecting the first volume of gas (14) and the trench (15) with the environment of the semiconductor device (10) such that the channel (16) is permeable for gases.

2. Semiconductor device (10) according to claim 1, wherein the environmental sensor (12) comprises a pressure sensor.

3. Semiconductor device (10) according to one of the preceding claims, wherein a closing body (17) is arranged at the side of the substrate body (13) that faces away from the environmental sensor (12).

4. Semiconductor device (10) according to the preceding claim, wherein the channel (16) is arranged within the closing body (17).

5. Semiconductor device (10) according to one of claims 3 or 4, wherein the closing body (17) comprises at least one electrically conductive via (32).

6. Semiconductor device (10) according to one of the preceding claims, wherein the trench (15) at least partially surrounds a decoupling portion (19) in lateral directions (x), where the decoupling portion (19) comprises the environmental sensor (12).

7. Semiconductor device (10) according to the preceding claim, wherein a second volume of gas (20) is arranged at the side of the decoupling portion (19) which faces away from the environmental sensor (12).

8. Semiconductor device (10) according to one of claims 6 to 7, wherein the decoupling portion (19) comprises a further environmental sensor (12).

9. Semiconductor device (10) according to one of claims 6 or 8, wherein the decoupling portion (19) is connected to the cap body (11).

10. Semiconductor device (10) according to one of the preceding claims, wherein the environmental sensor (12) is arranged on an integrated circuit (22).

11. Semiconductor device (10) according to one of the preceding claims, wherein the semiconductor device (10) is air-tight except for the channel (16).

12. Semiconductor device (10) according to one of the preceding claims, wherein the cap body (11) comprises at least one electrically conductive via (32).

## Patentansprüche

1. Halbleiterbauelement (10), umfassend:
- einen Kappenkörper (11),
- einen Umgebungssensor (12),
- einen Substratkörper (13),
- ein erstes Gasvolumen (14),
- einen Graben (15), der sich zumindest durch einen Teil des Substratkörpers (13) in einer vertikalen Richtung (z) erstreckt, wobei der Graben (15) mit dem ersten Gasvolumen (14) verbunden ist und die vertikale Richtung (z) senkrecht zu lateralen Richtungen (x), die parallel zur Haupterstreckungsebene des Halbleiterbauelements (10) sind, verläuft,
wobei
- der Graben (15) in lateraler Richtung (x) neben oder um den Umgebungssensor (12) angeordnet ist,
- der Umgebungssensor (12) in direktem Kontakt mit dem ersten Gasvolumen (14) steht, und
- der Umgebungssensor (12) und das erste Gasvolumen (14) in vertikaler Richtung (z) zwischen dem Kappenkörper (11) und dem Substratkörper (13) angeordnet sind,
**dadurch gekennzeichnet, dass**
das Halbleiterbauelement (10) ferner einen Kanal (16) umfasst, der sich in einer lateralen Richtung (x) erstreckt und das erste Gasvolumen (14) und den Graben (15) mit der Umgebung des Halbleiterbauelements (10) verbindet, so dass der Kanal (16) für Gase durchlässig ist.

2. Halbleiterbauelement (10) gemäß Anspruch 1, wobei der Umgebungssensor (12) einen Drucksensor aufweist.

3. Halbleiterbauelement (10) gemäß einem der vorhergehenden Ansprüche, wobei an der dem Umgebungssensor (12) abgewandten Seite des Substratkörpers (13) ein Abschlusskörper (17) angeordnet ist.

4. Halbleiterbauelement (10) gemäß dem vorhergehenden Anspruch, wobei der Kanal (16) innerhalb des Abschlusskörpers (17) angeordnet ist.

5. Halbleiterbauelement (10) gemäß einem der Ansprüche 3 oder 4, wobei der Abschlusskörper (17) zumindest eine elektrisch leitende Durchkontaktierung (32) umfasst.

6. Halbleiterbauelement (10) gemäß einem der vorhergehenden Ansprüche, wobei der Graben (15) einen Entkopplungsteil (19) in lateralen Richtungen (x) zumindest teilweise umgibt, wobei der Entkopplungsteil (19) den Umgebungssensor (12) aufweist.

7. Halbleiterbauelement (10) gemäß dem vorhergehenden Anspruch, wobei an der dem Umgebungssensor (12) abgewandten Seite des Entkopplungsteils (19) ein zweites Gasvolumen (20) angeordnet ist.

8. Halbleiterbauelement (10) gemäß einem der Ansprüche 6 bis 7, wobei der Entkopplungsteil (19) einen weiteren Umgebungssensor (12) umfasst.

9. Halbleiterbauelement (10) gemäß einem der Ansprüche 6 oder 8, wobei der Entkopplungsteil (19) mit dem Kappenkörper (11) verbunden ist.

10. Halbleiterbauelement (10) gemäß einem der vorhergehenden Ansprüche, wobei der Umgebungssensor (12) auf einer integrierten Schaltung (22) angeordnet ist.

11. Halbleiterbauelement (10) gemäß einem der vorhergehenden Ansprüche, wobei das Halbleiterbauelement (10) bis auf den Kanal (16) luftdicht ist.

12. Halbleiterbauelement (10) gemäß einem der vorhergehenden Ansprüche, wobei der Kappenkörper (11) zumindest eine elektrisch leitende Durchkontaktierung (32) umfasst.

## Revendications

1. Dispositif semi-conducteur (10), comprenant :
- un corps de bouchon (11),
- un capteur d'environnement (12),
- un corps de substrat (13),
- un premier volume de gaz (14),
- une tranchée (15) s'étendant à travers au moins une partie du corps de substrat (13) dans une direction verticale (z), la tranchée (15) étant connectée au premier volume de gaz (14) et la direction verticale (z) étant perpendiculaire aux directions latérales (x) qui sont parallèles au plan principal d'extension du dispositif semi-conducteur (10), dans lequel
- la tranchée (15) est arrangée à côté ou autour du capteur d'environnement (12) dans la direction latérale (x),
- le capteur d'environnement (12) est en contact direct avec le premier volume de gaz (14), et
- le capteur d'environnement (12) et le premier volume de gaz (14) sont arrangés entre le corps de bouchon (11) et le corps du substrat (13) dans la direction verticale (z), **caractérisé en ce que**
le dispositif semi-conducteur (10) comprend en outre un canal (16) s'étendant dans une direction latérale (x) et connectant le premier volume de gaz (14) et la tranchée (15) avec l'environnement du dispositif semi-conducteur (10) de sorte que le canal (16) est perméable aux gaz.

2. Dispositif semi-conducteur (10) selon la revendication 1, dans lequel le capteur d'environnement (12) comprend un capteur de pression.

3. Dispositif semi-conducteur (10) selon l'une des revendications précédentes, dans lequel un corps de fermeture (17) est arrangé sur le côté du corps de substrat (13) qui est opposé au capteur d'environnement (12).

4. Dispositif semi-conducteur (10) selon la revendication précédente, dans lequel le canal (16) est arrangé dans le corps de fermeture (17).

5. Dispositif semi-conducteur (10) selon l'une des revendications 3 ou 4, dans lequel le corps de fermeture (17) comprend au moins un via (32) électriquement conducteur.

6. Dispositif semi-conducteur (10) selon l'une des revendications précédentes, dans lequel la tranchée (15) entoure au moins partiellement une partie de découplage (19) dans des directions latérales (x), où la partie de découplage (19) comprend le capteur d'environnement (12).

7. Dispositif semi-conducteur (10) selon la revendication précédente, dans lequel un second volume de gaz (20) est arrangé sur le côté de la partie de découplage (19) qui est orienté à l'opposé du capteur d'environnement (12).

8. Dispositif semi-conducteur (10) selon l'une des revendications 6 à 7, dans lequel la partie de découplage (19) comprend un autre capteur d'environnement (12).

9. Dispositif semi-conducteur (10) selon l'une des revendications 6 ou 8, dans lequel la partie de découplage (19) est connectée au corps de bouchon (11).

10. Dispositif semi-conducteur (10) selon l'une des revendications précédentes, dans lequel le capteur d'environnement (12) est arrangé sur un circuit intégré (22).

11. Dispositif semi-conducteur (10) selon l'une des revendications précédentes, dans lequel le dispositif semi-conducteur (10) est étanche à l'air à l'exception du canal (16) .

12. Dispositif semi-conducteur (10) selon l'une des revendications précédentes, dans lequel le corps de bouchon (11) comprend au moins un via (32) électriquement conducteur.
